# EUROPEAN PATENT APPLICATION

(11) **EP 0 929 123 A1**
(43) Date of publication of application: **14.07.1999**
(21) Application number: 98110685.9
(22) Date of filing: 10.06.1998
(51) Int. Cl.: H01R 9/22

(54) **Heavy-current flowing circuit substrate, a method for producing the heavy-current flowing circuit substrate, and an assembled unit of a heavy-current flowing circuit substrate and a printed circuit substrate**

(30) Priority: 09.01.1998 JP 1502798
(71) Applicant: Moldec Co., Ltd., Adachi-gun, Fukushima (JP)
(72) Inventor: Takeuchi, Shinobu, Otama-mura, Adachi-gun, Fukushima (JP)
(74) Representative: Hartz, Nikolai, Dr.

(57) **Abstract**

A heavy-current flowing circuit substrate 1 comprises a resin-molded body 2 in which a plurality of bus bars 4 made of an elongated metallic plate 3 are embedded and both ends of each of the bus bars 4 are projected from the resin-molded body 2 so as to use them as connecting terminals, the heavy-current flowing circuit substrate 1 being attached or formed integrally with at least one printed circuit substrate 12 mounting thereon electronic devices 13.

## Description

The present invention relates to a heavy-current flowing circuit substrate and an assembled unit comprising a heavy-current flowing circuit substrate and a printed circuit substrate, which are used for a control circuit for controlling an electric motor and so on in which a heavy-current flowing circuit and a small-current flowing circuit are arranged in a mixed state, and a method for producing a heavy-current flowing circuit substrate.

Generally, when distribution cables (a wire harness) were extended near a rotating part of an automobile, the distribution cables were bound and fixed to a stationary portion so that the rotating part was not brought to contact with them. However, works for distributing and binding a number of the cables were troublesome and created a bottleneck in assembling operations in a large-scale production of automobiles. Further, since the bound cables could not be completely fixed, there was a danger of the coming-off due to vibrations during cruising of the automobile, thereby creating a problem of safeness.

Further, in a circuit portion where a heavy-current flowing circuit and a small-current flowing circuit are mixed in a printed circuit substrate on which a microcomputer is mounted to control a device operable by a heavy-current, there were such problems that wiring operations were troublesome because thicker cables were used for the heavy-current flowing circuit, and a space for wiring was increased.

It is an object of the present invention to provide a heavy-current flowing circuit substrate and a method for producing the same which simplify a wiring work and improves safeness by using standardized bus bars without wiring operations for cables.

It is an object of the present invention to provide an assembled unit comprising a heavy-current flowing circuit substrate and at least one printed circuit substrate which reduces a space for wiring and provides an effective wiring in a substrate portion where a heavy-current flowing circuit and a small-current flowing circuit are mixed.

In accordance with a first aspect of the present invention, there is provided a heavy-current flowing circuit substrate which comprises a resin-molded body and a plurality of bus bars made of an electric conductive material embedded in the resin-molded body wherein both ends of each of the bus bars are projected from the resin-molded body to use them as connecting terminals.

In accordance with a second aspect of the present invention, there is provided an assembled unit comprising a heavy-current flowing circuit substrate and at least one printed circuit substrate wherein the heavy-current flowing circuit substrate comprises a resin-molded body and a plurality of bus bars made of an electric conductive material embedded in the resin-molded body so that both ends of each of the bus bars are projected from the resin-molded body to use them as connecting terminals, and the printed circuit substrate on which a heavy-current flowing circuit and a minute-current flowing circuit are formed, is connected to the heavy-current flowing circuit substrate by connecting a terminal formed on the heavy-current flowing circuit with the connecting terminal.

In accordance with a third aspect of the present invention, there is provided a method for producing a heavy-current flowing circuit substrate which comprises perforating in a bus bar made of a metallic strip positioning openings with predetermined intervals along a longitudinal direction of the bus bar; placing a plurality of bus bars in metallic dies; supporting the bus bars by applying from a vertical direction core pins to the positioning openings; injecting molten resin into the metallic dies to embed the bus bars excluding their both ends; and withdrawing the core pins from the dies and opening the metallic dies to take out a resin-molded product.

In accordance with a fourth aspect of the present invention, there is provided a method for producing a heavy-current flowing circuit substrate which comprises placing a plurality of bus bars made of a metallic strip in metallic dies; supporting the bus bars by applying core pins from a vertical direction of the metallic dies; injecting molten resin into the metallic dies to embed the bus bars excluding their both ends; and withdrawing the core pins from the dies and opening the metallic dies to take out a resin-molded product.

In drawings:
Figure 1 is a perspective view of a heavy-current flowing circuit substrate according to an embodiment of the present invention;
Figure 2 is a cross-sectional view of the heavy-current flowing circuit substrate shown in Figure 1;
Figure 3 is a cross-sectional view partly omitted of the heavy-current flowing circuit substrate which shows an embodiment of the method according to the present invention;
Figures 4A to 4C are respectively cross-sectional views showing a method of producing the heavy-current flowing circuit substrate according to another embodiment of the present invention;
Figure 5A is a perspective view of an assembled unit comprising a heavy-current flowing circuit substrate and two printed circuit substrates according to an embodiment of the present invention;
Figure 5B is a diagram in an exploded state of the assembled unit shown in Figure 5A to show how a connecting terminal of a bus bar is connected to a circuit in a printed circuit substrate;
Figure 6 is a perspective view of an assembled unit comprising a heavy-current flowing circuit substrate and 4 printed circuit substrates according to another embodiment of the present invention;
Figure 7 is a perspective view of an assembled unit comprising an L-like heavy-current flowing circuit substrate and two printed circuit substrates according to another embodiment of the present invention;
Figure 8 is a perspective view of an assembled unit comprising a T-like heavy-current flowing circuit substrate and two printed circuit substrates according to another embodiment of the present invention;
Figure 9 is a perspective view of an assembled unit comprising a heavy-current flowing circuit substrate on which a printed circuit substrates is attached, according to another embodiment of the present invention;
Figure 10 is a perspective view of an assembled unit comprising a frame-like heavy-current flowing circuit substrate on which a printed circuit substrate is mounted, according to another embodiment of the present invention;
Figure 11 is a perspective view of a heavy-current flowing circuit substrate according to another embodiment of the present invention;
Figure 12 is an enlarged side view partly omitted of the heavy-current flowing circuit substrate shown in Figure 11;
Figure 13 is a perspective view of a heavy-current flowing circuit substrate according to another embodiment of the present invention;
Figure 14 is a side view partly omitted of the heavy-current flowing circuit substrate shown in Figure 13;
Figure 15 is a perspective view of a heavy-current flowing circuit substrate according to another embodiment of the present invention wherein a bus bar is utilized as a radiation fin;
Figure 16 is a cross-sectional view partly omitted of a heavy-current flowing circuit substrate according to another embodiment of the present invention wherein a shielding layer is formed; and
Figures 17A and 17B are respectively diagrams showing methods for producing the heavy-current flowing circuit substrate of the present invention.

Preferred embodiments of the present invention will be described in more detail with reference to the drawings wherein the same reference numerals designate the same or corresponding parts.

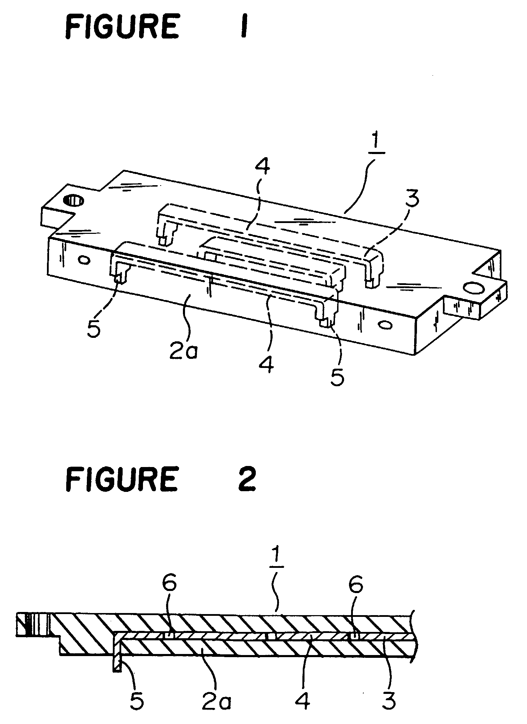

An embodiment of the heavy-current flowing circuit substrate of the present invention will be described with reference to Figures 1 and 2. In Figures 1 and 2, reference numeral 1 designates a heavy-current flowing circuit substrate. The circuit substrate 1 is in a flat plate-like shape and comprises a resin-molded body 2a and a plurality of bus bars 4 (there are three bus bars in this embodiment) made of an elongated electric conductive metallic plate, which are embedded in the resin-molded body 2 except for their respective both ends. These ends are projected from a surface of the resin-molded body 2a to use them as connecting terminals 5, 5. These connecting terminals of the bus bars may be projected from different surfaces of the resin-molded body 2a depending on a location or locations of a printed circuit substrate or substrates to be connected to the heavy-current flowing circuit substrate 1, as described hereinafter.

It is essential to place the bus bars 4 inside the resin-molded body 2a when it is molded.

Figure 3 is a cross-sectional view showing a method for producing the heavy-current flowing circuit substrate 1 according to an embodiment of the present invention. In the preparation of the circuit substrate 1, bus bars 4 are formed by cutting an elongated (a strip-like) metallic plate 3 to obtain predetermined lengths and by bending both ends of the cut metallic plates to thereby form connecting terminals 5, 5. A plurality of positioning openings 6 are formed in each of the bus bars 4 along their longitudinal direction with predetermined intervals. The bus bars 4 are set in metallic dies 9 in a state that a core pin 8a is fitted to each of the positioning opening 6 and a core pin 8b opposing the core pin 8a is to receive the free end of each of the core pins 8a so that the bus bars can be supported by these core pins 8a, 8b. After the setting of the bus bars 4 has been completed, molten resin is injected into the metallic dies 9, 9. Then, the core pins 8a, 8b are retracted and the molded heavy-current flowing circuit substrate 1 is removed from the metallic dies 9.

As a result of the method as described above, there remain recesses at portions where the core pins 8a, 8b have been retracted, whereby portions of the bus bars 4 are exposed. In order to eliminate these recesses, resin may be filled in the recesses later, or resin is injected during the molding operation by slightly raising and lowering the core pins 8a, 8b. Alternatively, the exposed portions of the bus bars 4 which have been formed by retracting the core pins 8a, 8b may be remained as they are, so that the exposed portions can be utilized as terminals for connecting lead wires. In the method as shown in Figure 3, a plurality of positioning opening 6 are formed in the bus bars 4 with predetermined intervals along their longitudinal direction, and the bus bars 4 are set in the metallic dies 9 in a state that the bus bars are held from the vertical direction by means of the core pins 8a, 8b, before molten resin is injected. Accordingly, the bus bars 4 can be embedded with high accuracy and in a horizontal state in the resin-molded body 2a.

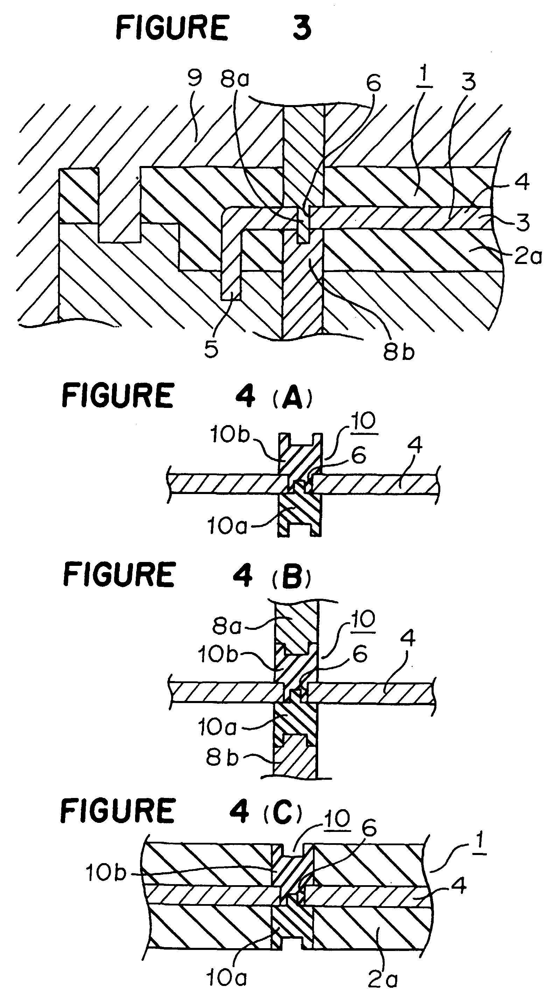

Figures 4A to 4C shows another embodiment of the method for producing the heavy-current flowing circuit substrate. In Figure 4A, an insulation snap 10 comprising a stud-side snap 10a and a socket-side snap 10b, is previously attached to each of the positioning openings 6 of the bus bars 4. Then, in Figure 4B, the bus bars 4 are set in metallic dies in a state that the insulating snap 10 is held from the vertical direction by means of core pins 8a, 8b. After the setting has been completed, molten resin is injected into the metallic dies. Then, a heavy-current flowing circuit substrate 1 in which the portions corresponding to the positioning openings 6 are occupied by the insulation snaps 10 is obtainable as shown in Figure 4C.

Figure 17A and 17B are diagrams showing respectively other methods for producing the heavy-current flowing circuit substrate of the present invention. The bus bars 4 used for the methods are not provided with positioning openings 6 unlike the cases as illustrated in Figures 3 and 4.

In Figure 17A, bus bars, 4 each of which is obtained by cutting an elongated metallic plate to have predetermined lengths and by bending an end or both ends of the bus bars according to requirement, are set in metallic dies 9. A pair of pins 8a, 8b, each having a flat free end, are extended from a vertical direction in an inner space of the metallic dies so that the bus bars 4 are held by the flat free ends of the core pins 8a, 8b. After the bus bars are fixed from the vertical direction by the core pins 8a, 8b, molten resin is injected into the metallic dies. Then, the core pins 8a, 8b are retracted in the vertical direction and a molded heavy-current flowing circuit substrate 1 is taken out from the metallic dies 9.

Figure 17B shows the substantially same method as in Figure 17A except that a channel-like recess is formed at each free end of the core pins 8a, 8b. When the core pins 8a, 8b are extended from a vertical direction in the metallic dies 9 to support the bus bars 4, the bus bars 4 can be restricted from both sides in a horizontal direction. According to this method, the bus bars 9 can certainly be positioned without a lateral shifting in the metallic dies 9.

The heavy-current flowing circuit substrate 1 having the above-mentioned construction of the present invention can be located in the vicinity of a rotating part in an automobile and can be connected to another circuit substrate by connecting the connecting terminals 6 to connectors (not shown) in the other circuit substrate without requiring a complicated wiring of distribution cables. The heavy-current flowing circuit substrate 1 facilitates wiring operations and provides easy assembling operations because the bus bars 4 for passing a heavy-current are embedded in and fixed to an intermediate portion of the resin-molded body 2a. Further, there is obtainable safetyness because there is no danger of contacting of current flowing portions to a rotating part of the automobile.

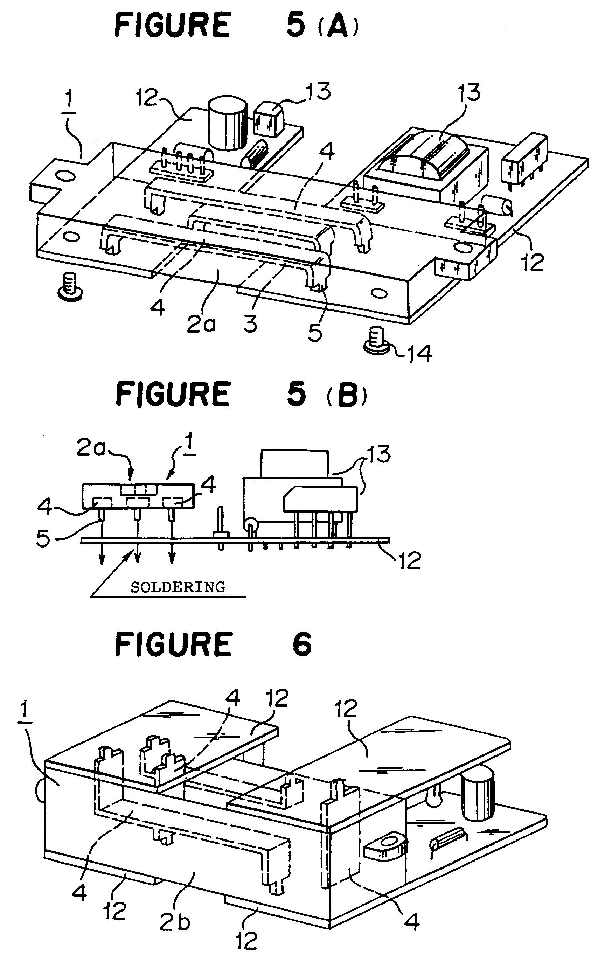

Figure 5A is a perspective view of an assembled unit comprising a heavy-current flowing circuit substrate and two printed circuit substrates 12, 12 mounted thereon electronic devices 13 and so on, according to an embodiment of the present invention. The heavy-current flowing circuit substrate 1 is such one as shown in Figure 1 and supports the two printed circuit substrates 12, 12 with use of screws 14, 14. The assembled unit is advantageous in a case that a heavy current for driving, for instance, a motor is passed to a bus bar 4 and the motor is controlled by a small current which is passed in a small-current flowing circuit formed in any of the printed circuit substrates 12.

Figure 5B is a diagram in an exploded state of the assembled unit shown in Figure 5A wherein the heavy-current flowing circuit substrate is connected to a printed circuit substrate by soldering the connecting terminals to predetermined portions of the printed circuit substrate.

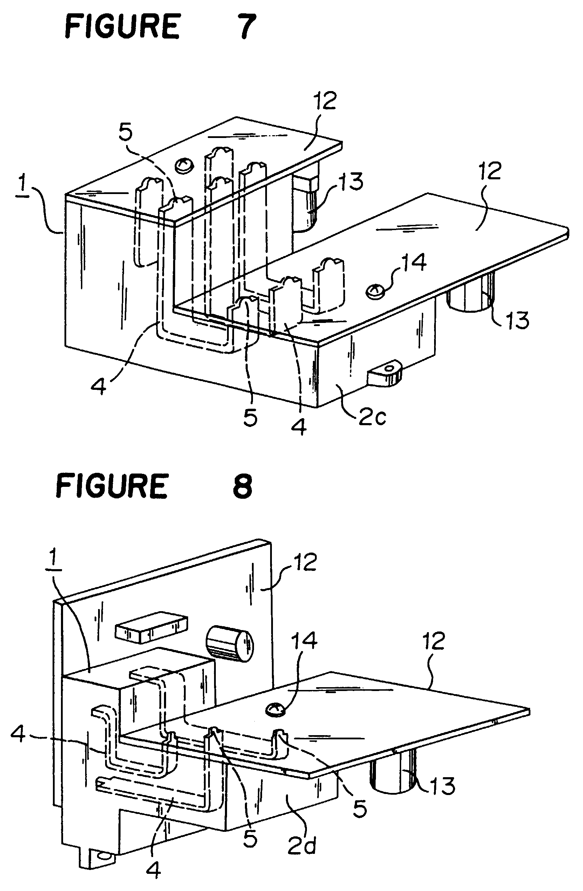

Figure 6 is a perspective view of another embodiment of the assembled unit of the present invention. In Figure 6, the heavy-current flowing circuit substrate 1 comprises a rectangular prism-like resin-molded body 2b in which a plurality of bus bars 4 are embedded in its lateral direction and longitudinal direction; connecting terminals at both ends of the bus bars are projected from different surfaces of the resin-molded body 2b; and four printed circuit substrates are attached to the surfaces of the resin-molded block 2b where the connecting terminals are projected. In this embodiment of the assembled unit, each two printed circuit substrates 12, 12 are respectively attached to upper and lower surfaces of the resin-molded body 12b in a vertically opposing state by interposing the resin-molded body 2b and these printed circuit substrates are electrically communicated with the bus bars 4.

Figure 7 is a perspective view showing another embodiment of the assembled unit of the present invention. In this embodiment, the heavy-current flowing circuit substrate 1 comprises an L-like resin-molded body 2c in which a plurality of bus bars 4 bent in an L-form are embedded, and both ends of each of the bus bars are projected from the resin-molded body 2c so as to use them as connecting terminals 5. In this specific embodiment, printed circuit substrates 12, 12 are placed on upward facing surfaces of the L-like resin-molded body 2c in a step-like manner. The printed circuit substrates 12, 12 are fixed to the block 2c by means of screws 14 and the connecting terminals 5 are connected to circuits in the printed circuit substrates 12 by soldering.

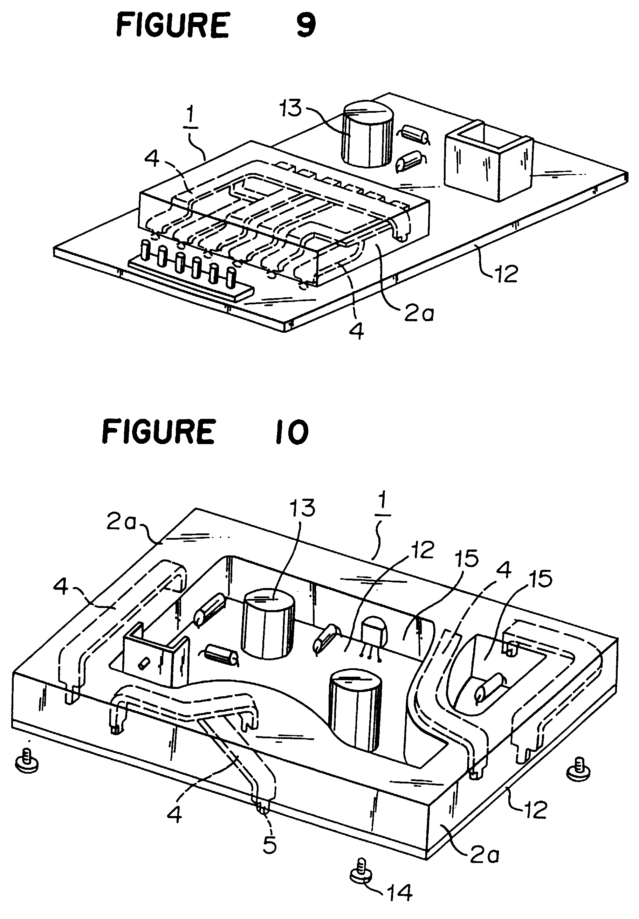

Figure 8 is a perspective view showing another embodiment of the assembled unit of the present invention. The heavy-current flowing circuit substrate 1 comprises a T-like resin-molded body 2d and a plurality of L-like and U-like bus bars 4 embedded in the resin-molded body 2d wherein the terminals 5 of the bus bars 4 are projected from surfaces of the resin-molded body 2d to be used as connecting terminals 5. In this embodiment, a first printed circuit substrate 12 is attached to the bottom surface of the T-like resin-molded body 2d in an inverted state and a second printed circuit substrate 12 is attached to a surface, which is perpendicular to the first printed substrate 12, of the molded body 2d, wherein these printed circuit substrates 12, 12 are fixed to the surfaces by means of screws and the connecting terminals 5 are soldered to circuits in the first and second printed circuit substrates.

Figure 9 is a perspective view showing another embodiment of the assembled unit of the present invention. In Figure 9, the heavy-current flowing circuit substrate 1 comprises a flat plate-like resin-molded body 2a and a plurality of bus bars 4 having various shapes, which are embedded in the resin-molded body 2a wherein the connecting terminals of the bus bars 4 are projected from a lower surface of the resin-molded body 2a. A printed circuit substrate 12 mounting thereon electronic devices 13 is fixed to the lower surface and the connecting terminals are electrically connected to circuits in the printed circuit substrate 12 in the same manner as the above-mentioned embodiments.

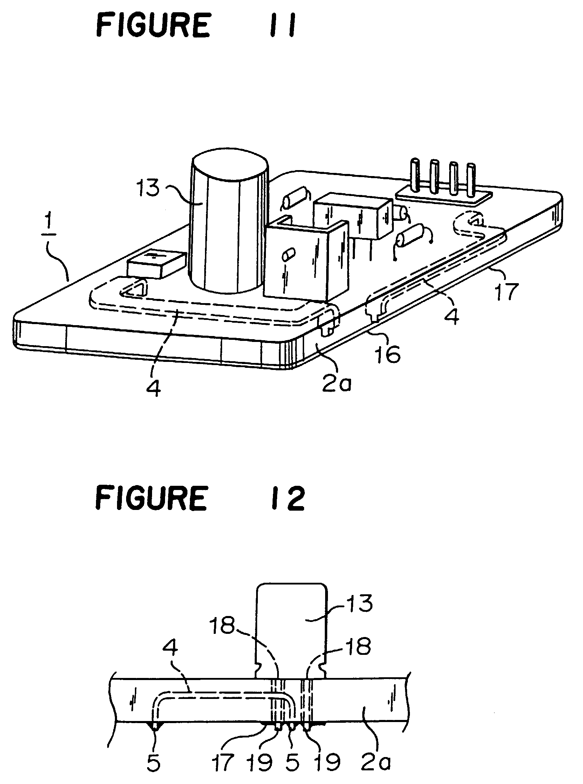

Figure 10 is a perspective view of another embodiment of the assembled unit of the present invention. The heavy-current flowing circuit substrate 1 comprises a resin-molded body 2a having a generally frame-like shape which is so formed as to have vertically hollowed openings 15, 15 and a plurality of bus bars 4 having various shapes which are embedded in the frame-like resin-molded body 2a. In this embodiment, a printed circuit substrate 12 is attached to a lower surface of the generally frame-like resin-molded body 2a by means of screws 14 so that electronic devices 13 are accommodated in the hollowed openings 15, 15. The bus bars 4 are connected to the printed circuit substrate 12 by soldering their connecting terminals to circuits formed in the printed circuit substrate 12 so as not to interfere with the electronic devices 13.

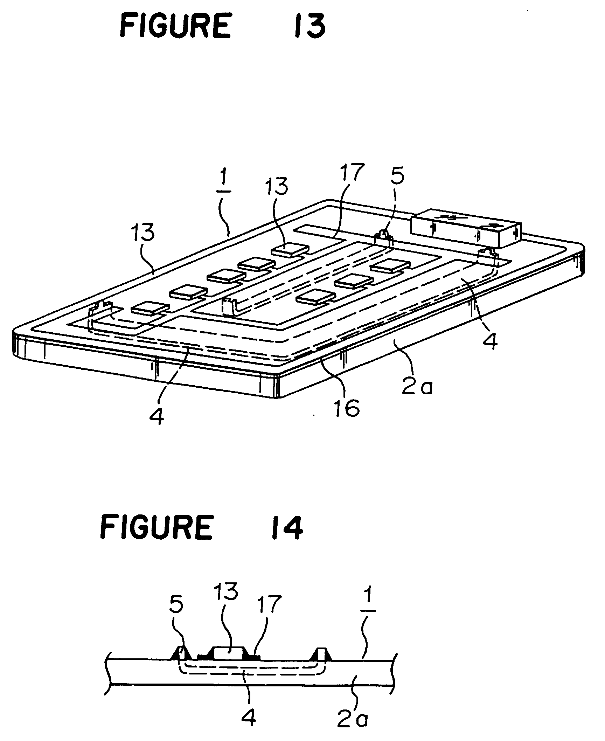

Figures 11 and 12 are respectively a perspective view and an enlarged side view showing another embodiment of the heavy-current flowing circuit substrate of the present invention. The heavy-current flowing circuit substrate 1 comprises a flat plate-like resin-molded body 2a and a plurality of bus bars 4 wherein the bus bars 4 are embedded in the resin-molded body 2a and both ends of the bus bars 4 are projected from a lower surface of the resin-molded body 2a. The heavy-current flowing circuit substrate is formed by attaching a copper foil 16 to the lower surface and etching the copper foil to obtain a desired circuit pattern to thereby form a printed circuit 17. In this embodiment, the printed circuit 17 is formed on the resin-molded body 2a as shown in Figure 12. Through holes 18 are formed to penetrate vertically the resin-molded body 2a. Electronic devices 13 are mounted on an upper surface of the resin-molded body 2a and the lead terminals of the electronic devices 13 are extended through the through holes 18 so as to be connected to circuits formed in the printed circuit substrate 17 by soldering.

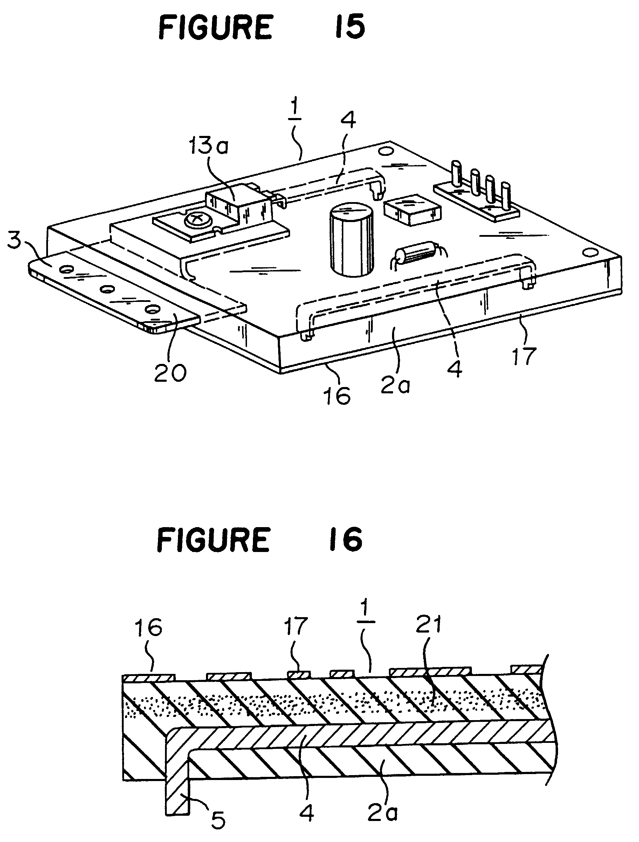

Figures 13 and 14 are respectively a perspective view and an enlarged side view partly omitted of another embodiment of the heavy-current flowing circuit substrate of the present invention. The heavy-current flowing circuit substrate 1 comprises a flat plate-like resin-molded body 2a and a plurality of bus bars 4 embedded in the resin-molded body 2a. A copper foil 16 is attached onto an upper surface of the resin-molded body 2a, the copper foil 16 being subjected to etching to thereby form a desired circuit pattern 17. Connecting terminals 5 of the bus bars 4 are connected to the circuit pattern 17. Electronic devices 13 are mounted on the upper surface of the resin-molded body 2a and are connected to the circuit pattern 17 by soldering.

Figure 15 is a perspective view of another embodiment of the heavy-current flowing circuit substrate of the present invention. The heavy-current flowing circuit substrate 1 comprises a flat plate-like resin-molded body 2a and a plurality of bus bars 4 embedded in the resin-molded body 2a. A copper foil 16 is attached to a lower surface of the resin-molded body 2a followed by etching so that a circuit pattern 17 is formed in the lower surface. In this embodiment, most of the both ends of the bus bars 4 are projected from the lower surface of the resin-molded body 2a so that they are used as connecting terminals connectable to the circuit pattern 17. In this specific embodiment of the present invention, an end portion of a bus bar is enlarged and projected from a side surface of the resin-molded body 2a so that the projected enlarged end portion is used as a radiation fin 20 and the other end of the bus bar 4 is exposed on an upper surface of the resin-molded body 2a. A heat generating component 13a such as a rectifier is attached to the exposed portion so that heat generated from the rectifier is discharged from the radiation fin 13.

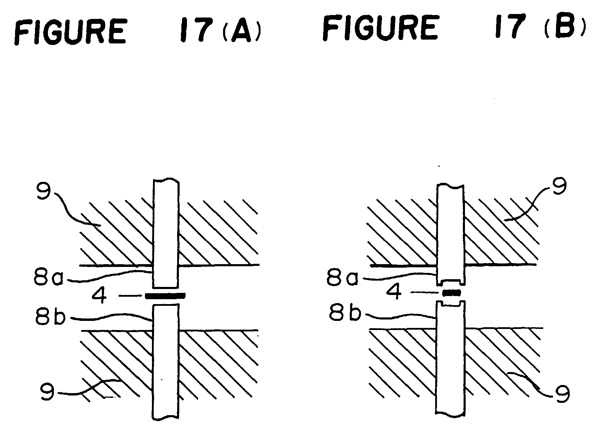

Figure 16 is another embodiment of the heavy-current flowing circuit substrate 1 of the present invention. The heavy-current flowing circuit substrate 1 comprises a flat plate-like resin-molded body 2a and a plurality of bus bars 4 embedded in the resin-molded body 2a wherein both ends of the bus bars are projected from a surface of the resin-molded body 2a. A printed circuit pattern 17 is formed on the surface opposite to the surface where the both ends of the bus bars 4 are projected. A shielding layer is formed between the bus bars 4 and the surface on which the printed circuit pattern 17 is formed. The shielding layer 21 may be a single layer or a plurality of layers. The shielding layer 21 is a layer composed of material selected from the group consisting of a metallic powder such as iron, copper or the like, a metallic plate, a metallic net, metallic wires and a silicon steel sheet as far as the shielding layer 21 can shield noises such as a magnetic flux and radiation. Further, the shielding layer 21 may be grounded by electrically connecting it with a bus bar 4.

As described above, according to the heavy-current flowing circuit substrate of the present invention wherein a plurality of bus bars are fixedly embedded in the resin-molded body, a complicated wiring operation is unnecessary and an assembling work can be easy. Further, it provides safetyness because there is no problem of contacting of a distribution cable to a rotating portion in an automobile

In accordance with the assembled unit of the present invention, there are obtainable the following advantages: (1) since the assembled unit is constituted by a heavy-current flowing circuit substrate and a plurality of printed circuit substrates, the substrates can firmly be located so as to direct desired orientations; (2) since the assembled unit can be used for a portion in which wiring is conducted in the conventional technique, the binding of wires becomes unnecessary (in particular, for a portion in which there is located a rotating element or a heating element to which there is a danger of the mutual contact of the element and the wire); and (3) working operations in an assembling line can be reduced because parts for the assembled unit can be standardized.

Further, in accordance with the method of producing a heavy-current flowing circuit substrate of the present invention, bus bars can be embedded in a resin-molded body at a correct position because bus bars are supported in metallic dies by fitting core pins to positioning openings formed in the bus bars.

## Claims

1. A heavy-current flowing circuit substrate which comprises a resin-molded body and a plurality of bus bars made of an electric conductive material embedded in the resin-molded body wherein both ends of each of the bus bars are projected from the resin-molded body to use them as connecting terminals.

2. The heavy-current flowing circuit substrate according to Claim 1, wherein the connecting terminals of each of the bus bars are projected from a surface of the resin-molded body; a printed circuit is formed in the surface opposing to the surface where the connecting terminals of the bus bars are projected, and a magnetic shielding layer is formed between the printed circuit and the bus bars in the resin-molded body.

3. The heavy-current flowing circuit substrate according to Claim 1, wherein the connecting terminals of each of the bus bars are projected from a surface of the resin-molded body; a printed circuit is formed in the same surface where the connecting terminals of the bus bars are projected; and the connecting terminals are connected to the printed circuit.

4. The heavy-current flowing circuit substrate according to Claim 2, wherein said magnetic shielding layer is a layer composed of material selected from the group consisting of a metallic powder, a metallic plate, a metallic net and metallic wires.

5. The heavy-current flowing circuit substrate according to Claim 1, wherein the resin-molded body has a shape selected from the group consisting of a flat plate-like shape, a rectangular prism-like shape, an L-shape, a T-shape and a frame-like shape.

6. The heavy-current flowing circuit substrate according to Claim 5, wherein the connecting terminals of the bus bars are projected from a surface or different surfaces of the resin-molded body.

7. The heavy-current flowing circuit substrate according to Claim 1, wherein a terminal for a lead wire is provided in a bus bar at an intermediate portion between the connecting terminals of the bus bar.

8. The heavy-current flowing circuit substrate according to Claim 1, wherein an end exposed to air of a bus bar is used as a radiation fin.

9. An assembled unit comprising a heavy-current flowing circuit substrate and at least one printed circuit substrate wherein
the heavy-current flowing circuit substrate comprises a resin-molded body and a plurality of bus bars made of an electric conductive material embedded in the resin-molded body so that both ends of each of the bus bars are projected from the resin-molded body to use them as connecting terminals, and
the printed circuit substrate on which a heavy-current flowing circuit and a minute-current flowing circuit are formed, is connected to the heavy-current flowing circuit substrate by connecting a terminal formed on the heavy-current flowing circuit with the connecting terminal.

10. The assembled unit according to Claim 9, wherein the resin-molded body has a shape selected from the group consisting of a flat plate-like shape, a rectangular prism-like shape, an L-shape, a T-shape, and a frame-like shape.

11. The assembled unit according to Claim 9, wherein the connecting terminals of the bus bars are projected from different surfaces of the resin-molded body, a plurality of printed circuit substrates are attached to the surfaces of the resin-molded body, and the connecting terminals are electrically connected to terminals of the printed circuit substrates.

12. A method for producing a heavy-current flowing circuit substrate which comprises:
perforating in a bus bar made of a metallic strip positioning openings with predetermined intervals along a longitudinal direction of the bus bar;
placing a plurality of bus bars in metallic dies;
supporting the bus bars by applying from a vertical direction core pins to the positioning openings;
injecting molten resin into the metallic dies to embed the bus bars excluding their both ends; and
withdrawing the core pins from the dies and opening the metallic dies to take out a resin-molded product.

13. The method according to Claim 12, wherein insulating snaps are previously attached to the positioning openings, and the core pins are applied from the vertical direction to the insulating snaps.

14. A method for producing a heavy-current flowing circuit substrate which comprises:
placing a plurality of bus bars made of a metallic strip in metallic dies;
supporting the bus bars by applying core pins from a vertical direction of the metallic dies;
injecting molten resin into the metallic dies to embed the bus bars excluding their both ends; and
withdrawing the core pins from the dies and opening the metallic dies to take out a resin-molded product. 15. The method according to Claim 14, wherein a recess portion is formed at the free end of each of the core pins so as to support the bus bars from their side direction.
